(19) Europäisches Patentamt
European Patent Office
Office européen des brevets

(11) **EP 4 487 718 A1**

(12) **EUROPEAN PATENT APPLICATION**
published in accordance with Art. 153(4) EPC

(43) Date of publication:
**08.01.2025   Bulletin 2025/02**

(21) Application number: 22929641.3

(22) Date of filing: **13.12.2022**

(51) International Patent Classification (IPC):
**A24F 40/51** (2020.01)        **A24F 40/40** (2020.01)

(86) International application number:
**PCT/CN2022/138536**

(87) International publication number:
**WO 2023/165214 (07.09.2023 Gazette 2023/36)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority:   **04.03.2022   CN 202210215103**

(71) Applicant: **Shenzhen Merit Technology Co., Ltd.
Shenzhen, Guangdong 518105 (CN)**

(72) Inventors:
• **WANG, Xin**
  Shenzhen, Guangdong 518105 (CN)
• **LIANG, Feng**
  Shenzhen, Guangdong 518105 (CN)
• **ZHOU, He**
  Shenzhen, Guangdong 518105 (CN)
• **HUANG, Zufu**
  Shenzhen, Guangdong 518105 (CN)

(74) Representative: **Manitz Finsterwald
Patent- und Rechtsanwaltspartnerschaft mbB
Martin-Greif-Strasse 1
80336 München (DE)**

(54) **AEROSOL GENERATION DEVICE AND ATOMIZATION CONTROL DEVICE THEREOF**

(57)    The present application relates to an aerosol generating device and an atomization control device thereof. The atomization control device includes: a capacitance measuring assembly (100), which is configured to generate a capacitance change based on whether an aerosol generating substrate is inserted, where capacitor electrode plates of the capacitance measuring assembly (100) are distributed along an insertion direction of the aerosol generating substrate; and a capacitance processing assembly (200), which is configured to identify a type of the aerosol generating substrate based on a capacitance of the capacitance measuring assembly (100), and determine a heating control mode for the aerosol generating device based on the type of the aerosol generating substrate, where the capacitance processing assembly (200) is connected to the capacitance measuring assembly (100). The capacitance measuring assembly (100) generates the capacitance change based on whether the aerosol generating substrate is inserted, the capacitance processing assembly (200) identifies the type of the aerosol generating substrate based on the capacitance of the capacitance measuring assembly (100), and determines the heating control mode of the aerosol generating device according to the aerosol generating substrate type; automatic adjustment of heating control modes according to the aerosol generating substrate type is achieved.

FIG. 1

EP 4 487 718 A1

# Description

## CROSS-REFERENCE TO RELATED APPLICATIONS

The present application claims priority to Chinese patent application No. 202210215103.4, filed on March 4, 2022, entitled "AEROSOL GENERATION DEVICE AND ATOMIZATION CONTROL DEVICE THEREOF", the entire content of which is incorporated herein by reference.

## TECHNICAL FIELD

The present disclosure relates to the field of electronic devices, and in particular, to an aerosol generating device and an atomization control device thereof.

## BACKGROUND

Aerosol generating devices are electronic devices that heat an aerosol generating substrate to form aerosols that can be inhaled by users. The aerosol generating devices are popular among users because they do not contain harmful substances such as tar and will not cause any harm to smokers. For different types of aerosol generating substrates, the heating temperature control method will also be different. Conventional aerosol generating devices require inputting instructions through buttons to determine a type of the aerosol generating substrate, which is inconvenient to use.

## SUMMARY

Based on this, it is necessary to provide an aerosol generating device and an atomization control device thereof that can improve convenience of use in order to address the problem of low convenience of use of conventional aerosol generating devices.

An atomization control device for an aerosol generating device, includes:

a capacitance measuring assembly configured to generate a capacitance change based on whether an aerosol generating substrate is inserted, capacitor plates of the capacitance measuring assembly being distributed along an insertion direction of the aerosol generating substrate; and
a capacitance processing assembly configured to identify a type of the aerosol generating substrate based on a capacitance of the capacitance measuring assembly, and determine a heating control mode for the aerosol generating device based on the type of the aerosol generating substrate, the capacitance processing assembly being connected to the capacitance measuring assembly.

In an embodiment, the capacitance processing assembly is further configured to determine a state of the aerosol generating substrate based on the capacitance of the capacitance measuring assembly, and perform heating control on the aerosol generating device based on the state of the aerosol generating substrate.

In an embodiment, the capacitance processing assembly is further configured to control the aerosol generating device to start heating when it is identified that the aerosol generating substrate is inserted based on the capacitance of the capacitance measuring assembly, and control the aerosol generating device to stop heating when it is identified that the aerosol generating substrate is pulled out based on the capacitance of the capacitance measuring assembly.

In an embodiment, the number of the capacitor plates is three or more, and the capacitance processing assembly is configured to control the aerosol generating device to start a preheating stage when the aerosol generating substrate is in a state of being inserted, and control the aerosol generating device to start a heating stage when the aerosol generating substrate is completely inserted. The capacitance processing assembly is also configured to control the aerosol generating device to end the heating in advance or reduce a heating temperature when the aerosol generating substrate is in a state of being pulled out.

In an embodiment, the capacitance measuring assembly includes a to-be-measured capacitor, and the to-be-measured capacitor is connected to the capacitance processing assembly.

In an embodiment, the to-be-measured capacitor includes the capacitor plates and a base body made of a non-conductive material, and the capacitor plates are disposed on the base body. A number of the capacitor plates is two or more.

In an embodiment, the capacitor plates are closed annular plates or non-closed annular plates.

In an embodiment, the capacitor plates each include an annular portion and an extension portion disposed on the annular portion, the number of the capacitor plates is two, and the extension portions of the two capacitor plates are disposed opposite to each other.

In an embodiment, the base body is a hollow cylindrical base body, and the capacitor plates are located outside or inside of the base body and distributed along a longitudinal direction of the base body.

In an embodiment, the number of the capacitor plates is two, and the capacitor plates are located on a cylindrical inner wall surface or outer wall surface of the base body.

In an embodiment, the number of the capacitor plates is two, one end of the base body is closed to form a bottom wall, and one of the capacitor plates is disposed on the bottom wall of the base body.

In an embodiment, the to-be-measured capacitor further includes a heating element disposed on the base body.

In an embodiment, the capacitor plates form annular plate groups in a one-to-many or many-to-many manner.

In an embodiment, the to-be-measured capacitor includes a base body made of a conductive material, and the base body is divided into two or more capacitor plates.

In an embodiment, the capacitor plates are closed annular plates or non-closed annular plates.

In an embodiment, the to-be-measured capacitor further includes an insulating member disposed between the capacitor plates.

In an embodiment, the capacitor plates and the insulating member are hollow and are configured to receive the aerosol generating substrate together.

In an embodiment, the capacitor plates form annular plate groups in a one-to-many or many-to-many manner.

In an embodiment, the capacitance processing assembly includes a capacitance acquisition component and a main control unit, and the capacitance acquisition component is connected to the capacitance measuring assembly and the main control unit.

An aerosol generating device includes the above-mentioned atomization control device.

In the above-mentioned aerosol generating device and atomization control device thereof, the capacitor plates of the capacitance measuring assembly are distributed along the insertion direction of the aerosol generating substrate. The capacitance measuring assembly generates a capacitance change based on whether the aerosol generating substrate is inserted. The capacitance processing assembly identifies the type of the aerosol generating substrate based on the capacitance of the capacitance measuring assembly, and determines the heating control mode for the aerosol generating device based on the type of the aerosol generating substrate. In this way, the heating control mode is automatically adjusted based on the type of the aerosol generating substrate without requiring a user to operate buttons, thereby improving the convenience of use.

## BRIEF DESCRIPTION OF THE DRAWINGS

In order to more clearly illustrate technical solutions in the embodiments of the present disclosure or conventional technologies, the accompanying drawings required for use in the description of the embodiments or the conventional technologies are briefly introduced below. Obviously, the accompanying drawings described below are only some embodiments of the present disclosure, and for those of ordinary skill in the art, other drawings can be derived from these drawings without creative efforts.

FIG. 1 is a block diagram of a configuration of an atomization control device for an aerosol generating device in an embodiment of the present disclosure.
FIG. 2 is a schematic structural diagram showing various shapes of capacitor plates in an embodiment of the present disclosure.
FIG. 3 is a schematic diagram of a structure of a capacitance measuring assembly in an embodiment of the present disclosure.
FIG. 4 is a schematic diagram of a structure of a capacitance measuring assembly in another embodiment of the present disclosure.
FIG. 5 is a schematic diagram of capacitor plates forming annular plate groups in an embodiment of the present disclosure.
FIG. 6 is a schematic diagram of capacitor plates forming annular plate groups in another embodiment of the present disclosure.
FIG. 7 is a schematic diagram of a bottom plate and a capacitor plate forming an equivalent capacitor in an embodiment of the present disclosure.
FIG. 8 is a schematic diagram of a bottom plate and a capacitor plate forming an equivalent capacitor in another embodiment of the present disclosure.
FIG. 9 is a schematic diagram of a structure of a capacitor plate in an embodiment of the present disclosure.
FIG. 10 is a schematic diagram of a structure of a capacitance measuring assembly in another embodiment of the present disclosure.
FIG. 11 is a schematic diagram of a structure of a capacitance measuring assembly in another embodiment of the present disclosure.
FIG. 12 is a schematic diagram of capacitor plates forming annular plate groups in another embodiment of the present disclosure.
FIG. 13 is a schematic diagram of capacitor plates forming annular plate groups in yet another embodiment of the present disclosure.
FIG. 14 is a schematic diagram of a bottom plate and a capacitor plate forming an equivalent capacitor in another embodiment of the present disclosure.
FIG. 15 is a schematic diagram of a bottom plate and a capacitor plate forming an equivalent capacitor in yet another embodiment of the present disclosure.
FIG. 16 is a front view of a base body in an embodiment of the present disclosure.
FIG. 17 is a schematic diagram of equivalent capacitors in an embodiment of the present disclosure.
FIG. 18 is a schematic diagram of a principle of detecting position information of an inserted aerosol generating substrate in an embodiment of the present disclosure.
FIG. 19 is a schematic diagram of capacitor plates when a capacitance measuring assembly is an independent measured assembly in an embodiment of the present disclosure.
FIG. 20 is a schematic diagram of capacitor plates when a to-be-measured capacitor component is a series-type composite measured assembly in an embodiment of the present disclosure.
FIG. 21 is a schematic diagram of capacitor plates when a capacitance measuring assembly is a parallel-type composite measured assembly in an embodiment of the present disclosure.

FIG. 22 is a schematic diagram of capacitor plates when a capacitance measuring assembly is a composite-type composite measured assembly in an embodiment of the present disclosure.

FIG. 23 is a schematic diagram of capacitor plates when a capacitance measuring assembly is a composite-type composite measured component in another embodiment of the present disclosure.

FIG. 24 is a schematic diagram of a connection between a touch control chip and a capacitance measuring assembly in an embodiment of the present disclosure.

FIG. 25 is a schematic diagram of a connection between a touch control chip and a capacitance measuring assembly in another embodiment of the present disclosure.

## DETAILED DESCRIPTION OF THE EMBODIMENTS

In order to make the purpose, technical solution and advantages of the present disclosure more obvious and understandable, the present disclosure is further described in detail below with reference to the accompanying drawings and embodiments. It should be understood that the specific embodiments described herein are only used to explain the present disclosure and are not used to limit the present disclosure.

Unless otherwise defined, all technical and scientific terms used herein have the same meaning as those commonly understood by those skilled in the art to which the present disclosure belongs. The terms used herein in the specification of the present disclosure are only for the purpose of describing specific embodiments and are not intended to limit the present disclosure.

It can be understood that the "connection" in the following embodiments should be understood as "electrical connection", "communication connection", etc. if the connected circuits, modules, units, etc. have electrical signals or data transmission between each other.

Conventional aerosol generating devices require inputting instructions through buttons to determine a type of an aerosol generating substrate, which is inconvenient to use. Based on this, the present disclosure provides an aerosol generating device and an atomization control device thereof. A capacitance measuring assembly generates a capacitance change based on whether an aerosol generating substrate is inserted. A capacitance processing assembly identifies the type of the aerosol generating substrate based on the capacitance of the capacitance measuring assembly, and determines a heating control mode for the aerosol generating device based on the type of the aerosol generating substrate, so that automatic adjustment of the heating control mode based on the type of the aerosol generating substrate is achieved without requiring a user to operate buttons, thereby enhancing human-machine interaction and human experience. In addition, the capacitance processing assembly further determines a state of the aerosol generating substrate based on the capacitance of the capacitance measuring assembly, and performs heating control on the aerosol generating device based on the state of the aerosol generating substrate, so as to intelligently determine the insertion of the aerosol generating substrate to intelligently start the heating of the aerosol generating substrate, and to intelligently determine the removal of the aerosol generating substrate to intelligently stop the heating of the aerosol generating substrate, that is, stopping the heating immediately upon the removal of the aerosol generating substrate. Additionally, it can avoid misheating when there is no aerosol generating substrate in the aerosol generating device, and prevent dry burning when there is no aerosol generating substrate, thus the device has a certain degree of intelligent safety. In an embodiment, the aerosol generating substrate is solid substrate configured to generate aerosol when heated. In some embodiments, the aerosol generating substrate includes tobacco-containing material, and the tobacco-containing material contains volatile tobacco flavor compounds released from the substrate when heated. The aerosol generating substrate may include non-tobacco material. The solid substrate may contain materials such as herbaceous plant leaves, and tobacco leaves, etc. In other embodiments, the aerosol generating substrate may also be a liquid substrate, which is atomized to form aerosols when being heated.

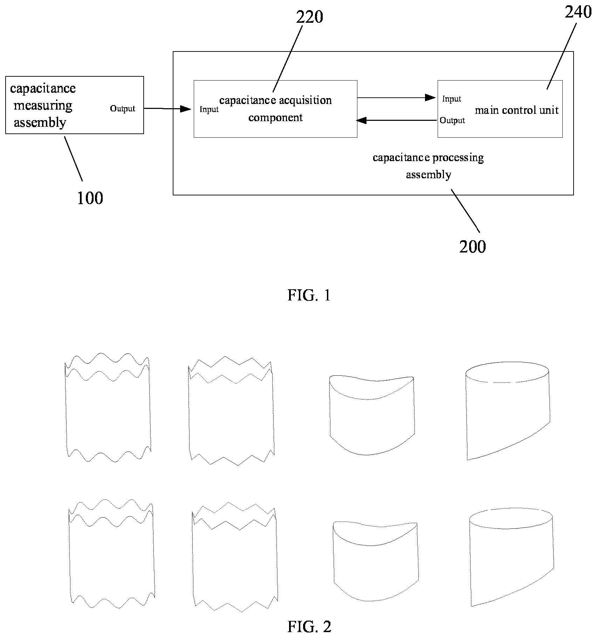

In an embodiment, as shown in FIG. 1, an atomization control device for an aerosol generating device is provided, including a capacitance measuring assembly 100 and a capacitance processing assembly 200. Capacitor plates of the capacitance measuring assembly 100 are distributed along an insertion direction of the aerosol generating substrate. The capacitance processing assembly 200 is connected to the capacitance measuring assembly 100. The capacitance measuring assembly 100 generates a capacitance change based on whether the aerosol generating substrate is inserted. The capacitance processing assembly 200 identifies a type of the aerosol generating substrate based on the capacitance of the capacitance measuring assembly 100, and determines a heating control mode for the aerosol generating device based on the type of the aerosol generating substrate.

The capacitance measuring assembly 100 can be mounted in a cavity for inserting the aerosol generating substrate in the aerosol generating device. When the aerosol generating substrate is inserted into or pulled out of the aerosol generating device by a user, the capacitance of the capacitance measuring assembly 100 changes based on an actual insertion position of the aerosol generating substrate. The capacitance processing assembly 200 can pre-store the capacitances of the capacitance measuring assembly 100 when different types of aerosol generating substrates are inserted. After measuring the actual capacitance of the capacitance measuring assembly 100, the type of the currently inserted aerosol generating substrate can be identified, and then the heating control mode for the aerosol generating device can be adjusted based on the type of the aerosol generating substrate. For example, a correspondence between different capacitance value ranges and the types of aerosol generating substrates is established and stored in the capacitance processing assembly 200. After measuring an actual capacitance value of the capacitance measuring assembly 100, the capacitance processing assembly 200 can directly identify the type of the aerosol generating substrate based on the capacitance value range in which the actual capacitance value is located.

Furthermore, specific heating control modes for different types of aerosol generating substrates are not limited and can be set based on actual designs. The capacitance processing assembly 200 can further pre-store the heating control modes for different types of aerosol generating substrates, such as heating methods and temperature control methods. After identifying the type of the inserted aerosol generating substrate, the capacitance processing assembly 200 can use different heating methods and temperature control methods based on different types of aerosol generating substrates to enhance human-machine interaction and human experience.

In an embodiment, the capacitance processing assembly 200 is further configured to determine the state of the aerosol generating substrate based on the capacitance of the capacitance measuring assembly, and perform heating control on the aerosol generating device based on the state of the aerosol generating substrate. The capacitance processing assembly 200 can pre-store an initial capacitance value of the capacitance measuring assembly 100 as a comparison threshold. After measuring the actual capacitance of the capacitance measuring assembly 100, the capacitance processing assembly 200 can compare the measured actual capacitance of the capacitance measuring assembly 100 with the comparison threshold to determine whether the aerosol generating substrate being in an inserted state or pulled out state, and then perform heating control on the aerosol generating device based on the state of the aerosol generating substrate. For example, the capacitance processing assembly 200 controls a power supply module to supply power to start the heating when it is identified that the aerosol generating substrate is inserted. The capacitance processing assembly 200 also controls the power supply module to turn off the power to end the heating when it is identified that the aerosol generating substrate is pulled out.

The number of the capacitor plates of the capacitance measuring assembly 100 is not limited, and may be two, three, or more. For example, when the capacitance measuring assembly 100 includes two capacitor plates, it is possible to identify whether the aerosol generating substrate being in an inserted state or a pulled out state based on the capacitance of the capacitance measuring assembly 100. Further, when the capacitance measuring assembly 100 includes three or more capacitor plates, it is possible to identify a present insertion position of the aerosol generating substrate and whether it is in the state of being inserted or being pulled out based on the capacitance of the capacitance measuring assembly 100.

The mode in which the capacitance processing assembly 200 performs heating control on the aerosol generating device based on the state of the aerosol generating substrate is not limited. In an embodiment, the capacitance processing assembly 200 controls the aerosol generating device to start heating when it identifies that the aerosol generating substrate is inserted based on the capacitance of the capacitance measuring assembly 100. The capacitance processing assembly 200 also controls the aerosol generating device to stop heating when it identifies that the aerosol generating substrate is pulled out based on the capacitance of the capacitance measuring assembly 100.

Further, when the number of the capacitor plates is three or more, the capacitance processing assembly 200 controls the aerosol generating device to start a preheating stage when the aerosol generating substrate is in the state of being inserted, and controls the aerosol generating device to start a heating stage when the aerosol generating substrate is completely inserted. The capacitance processing assembly 200 further controls the aerosol generating device to end the heating in advance or reduce the heating temperature when the aerosol generating substrate is in the state of being pulled out. Specifically, based on the measured actual capacitance of the capacitance measuring assembly 100, the capacitance processing assembly 200 determines whether the aerosol generating substrate is in the state of being inserted or being pulled out and an actual present position of the aerosol generating substrate. It starts the preheating stage when the aerosol generating substrate is in the state of being inserted, and start the heating stage when the aerosol generating substrate is completely inserted. The power of starting the preheating stage is less than the power of starting the heating stage, and specific values of the powers can be set based on an actual situation. When the aerosol generating substrate is in the state of being pulled out, the capacitance processing assembly 200 further controls to end the heating in advance or reduce the heating temperature. Furthermore, if the operation of reducing the heating temperature is performed while the aerosol generating substrate is being pulled out, the capacitance processing assembly 200 completely ends the heating when it is identified that the aerosol generating substrate is completely pulled out.

A specific structure of the capacitance processing assembly 200 is not limited. In an embodiment, the capacitance processing assembly 200 includes a capacitance acquisition component 220 and a main control unit 240. The capacitance acquisition component 220 connects the capacitance measuring assembly 100 and the main control unit 240. An output terminal of the capacitance measuring assembly 100 is connected to an input terminal of the capacitance acquisition component 220. The capacitance acquisition component 220 is connected to an input terminal and output terminal of the main control unit 240. The capacitance acquisition component 220 may be a touch chip, a 555 timer, an RC circuit, or other circuits that can acquire capacitance. The capacitance acquisition component 220 converts the capacitance change into electrical quantities, such as voltage, current, resistance, frequency, phase, etc., and then the main control unit 240 processes the electrical quantity data output by the capacitance acquisition component 220, so as to control the external device. In addition, in an embodiment, the capacitance acquisition component 220 can further include a touch chip and a detection circuit. The touch chip is connected to the capacitance measuring assembly 100 through the detection circuit. The detection circuit may specifically include a capacitor configured to be connected in series or parallel with the capacitor plate of the capacitance measuring assembly 100.

In the above-mentioned atomization control device for the aerosol generating device, the capacitance measuring assembly 100 generates the capacitance change based on whether the aerosol generating substrate is inserted, and the capacitance processing assembly 200 identifies the type of the aerosol generating substrate based on the capacitance of the capacitance measuring assembly 100, and determines the heating control mode for the aerosol generating device based on the type of the aerosol generating substrate, realizing automatic adjustment of the heating control mode based on the type of the aerosol generating substrate without requiring the user to operate buttons, thereby improving the convenience of use.

In an embodiment, the capacitance measuring assembly 100 includes to-be-measured capacitors, and the to-be-measured capacitors are connected to the capacitance processing assembly 200. The to-be-measured capacitor can be designed as an annular capacitor. Specifically, the to-be-measured capacitors can be set in a cavity for inserting the aerosol generating substrate in the aerosol generating device. The capacitance processing assembly 200 measures the actual capacitance values of the to-be-measured capacitors and compares the measured actual capacitance values with a corresponding preset initial capacitance value to determine whether the capacitance value of each to-be-measured capacitor has changed, thereby obtaining the present position of the aerosol generating substrate and whether the aerosol generating substrate is in a state of being inserted state or being pulled out. In addition, the capacitance processing assembly 200 can further directly identify the type of the aerosol generating substrate based on the capacitance value range in which the actual capacitance value of the to-be-measured capacitor is located.

A specific structure of the to-be-measured capacitor is not limited. Material of a base body of the to-be-measured capacitor can include conductive material and non-conductive material. Depending on different materials of the base body, the design of the capacitor plate will also be different accordingly. In an embodiment, the to-be-measured capacitor includes capacitor plates and a base body made of a non-conductive material, and the capacitor plates are arranged on the base body. The number of the capacitor plates is two or more. In the insertion direction of the aerosol generating substrate (for example, when inserted vertically), the two or more capacitor plates are located at different horizontal heights. The capacitor plates are closed annular plates or non-closed annular plates. Specifically, the base body can be designed as a hollow cylindrical base body and is configured to receive the aerosol generating substrate. Each of the capacitor plates surrounds the base body, and specifically, the capacitor plates are located outside or inside of the base body and distributed along the longitudinal direction of the base body. In an embodiment, the number of the capacitor plates is two, and the capacitor plates are located on a cylindrical inner wall or outer wall of the base body. Specifically, the cylindrical base body can be designed to be open at both ends, and then the capacitor plates are arranged on the cylindrical inner wall or outer wall of the base body.

The capacitor plate can be a metal plate, which can be a flexible plate or an electroplated plate. The profile of the annular capacitor plate can be circular, rectangular, arched, triangular, spiral, or a composite of these shapes. In addition, as shown in FIG. 2, the edges of the two ends of the capacitor plate can be one or more sections of linear, nonlinear, planar, or non-planar.

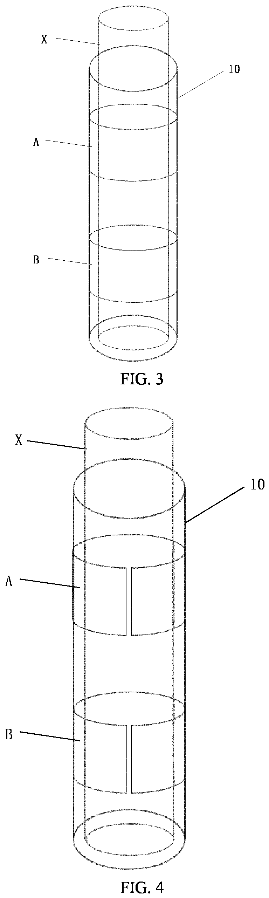

As shown in FIG. 3 and FIG. 4, capacitor plate A and capacitor plate B may be provided on a non-conductive base body 10 by laminating, coating, or electroplating. The capacitor plate A and the capacitor plate B form an equivalent capacitor. Each capacitor plate may have a closed structure or a non-closed structure, or may be any combination of a closed annular plate and a non-closed annular plate.

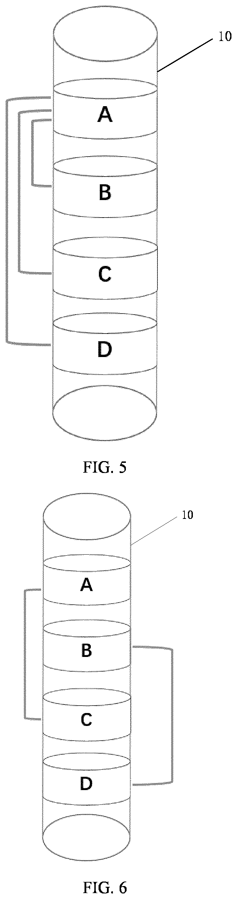

Furthermore, the capacitor plates form annular plate groups in a one-to-many or many-to-many manner. For example, when the number of the capacitor plates is two, the two capacitor plates form an annular plate group. When the number of the capacitor plates is greater than or equal to three, the capacitor plates can form annular plate groups in a one-to-many or many-to-many manner. Specifically, there can be multiple annular plate groups on the base body 10 in one-to-many form. As shown in FIG. 5, the capacitor plate A and the capacitor plate B form a group of electrodes, the capacitor plate A and the capacitor plate C form a group of electrodes, and the capacitor plate A and the capacitor plate D form a group of electrodes. It can also be many-to-many, as shown in FIG. 6, the capacitor plate A and the capacitor plate C form a group of electrodes, and the capacitor plate B and the capacitor plate D form a group of electrodes.

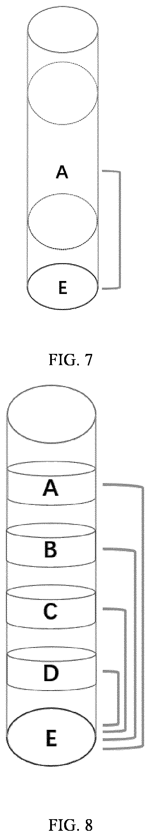

In addition, in an embodiment, a capacitor plate can also be set at the bottom of the base body 10 as a bottom plate, and the bottom plate and other corresponding capacitor plates form equivalent capacitors. The shape of the bottom plate is not limited, and can be rectangular, circular, triangular, arched, spiral, and a composite of these shapes. As shown in FIG. 7, there is a bottom plate E at the bottom of the base body 10, and the bottom plate E and annular capacitor plates form one or more equivalent capacitors. For example, as shown in FIG. 7, the capacitor plate A and the bottom plate E constitute an equivalent capacitor. Alternatively, as shown in FIG. 8, the capacitor plate A and the bottom plate E constitute an equivalent capacitor, the capacitor plate B and the bottom plate E constitute an equivalent capacitor, the capacitor plate C and the bottom plate E constitute an equivalent capacitor, and the capacitor plate D and the bottom plate E constitute an equivalent capacitor.

In an embodiment, the number of the capacitor plates is two, one end of the base body 10 is closed to form a bottom wall, and one of the capacitor plates is disposed on the bottom wall of the base body 10. Specifically, two capacitor plates are disposed longitudinally inside the base body 10, one of which is located on the bottom wall of the base body 10 as a bottom plate, and the other capacitor plate is located on the side wall of the base body 10. By the two capacitor plates, it can be identified whether the aerosol generating substrate is inserted, and the structure is simple.

In addition, the to-be-measured capacitor may also include a heating element disposed on the base body 10. The heating element may be a resistive heat generating line printed on the base body 10, and is configured to heat the aerosol generating substrate.

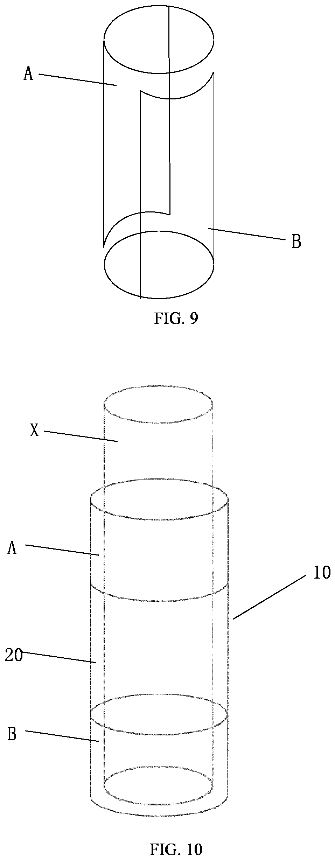

In an embodiment, as shown in FIG. 9, the capacitor plate includes an annular portion and an extension portion disposed on the annular portion. The number of the capacitor plates is two, and the extension portions of the two capacitor plates are disposed opposite to each other. Specifically, the capacitor plate A and the capacitor plate B are each designed to be a structure consisting of an annular portion and an extension portion, the extension portion of the capacitor plate is disposed on the annular portion and is perpendicular to the curved surface where the annular portion is located, and the extension portions of the two capacitor plates are disposed opposite to each other. By measuring the actual capacitance values of the two capacitor plates, the state of the aerosol generating substrate can also be identified.

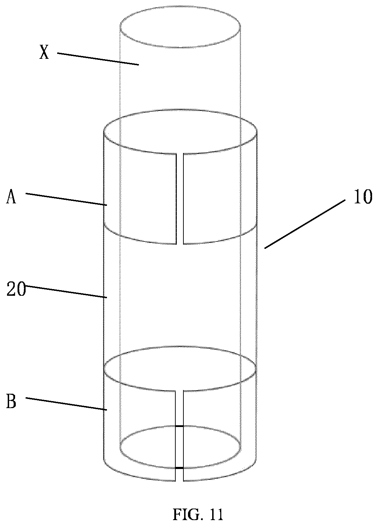

In another embodiment, as shown in FIG. 10, the to-be-measured capacitor includes a base body 10 made of a conductive material. The base body 10 is divided into two or more capacitor plates, and can be specifically divided into three capacitor plates. The capacitor plates form annular plate groups in a one-to-many or many-to-many manner. Specifically, when the base body 10 is made of the conductive material, the base body 10 serves as both a heating element and a capacitor plate. The base body 10 is divided into a plurality of annular capacitor plates, and as shown in FIG. 10 and FIG. 11, the capacitor plate A and the capacitor plate B formed by the division of the base body 10 form an equivalent capacitor. Each capacitor plate is an annular capacitor plate, which can be closed or non-closed, or any combination of the closed annular plate and the non-closed annular plate. The capacitor plate A and the capacitor plate B are both made of metal, and can receive the aerosol generating substrate and generate heat through an external alternating magnetic field, thereby heating the aerosol generating substrate. In addition, the to-be-measured capacitor also includes an insulating member arranged between the capacitor plates. For example, an insulating member 20 is arranged between the capacitor plate A and the capacitor plate B. The insulating member 20 may be made of ceramic. In this embodiment, the capacitor plate and the insulating member 20 are hollow and are configured to receive the aerosol generating substrate together.

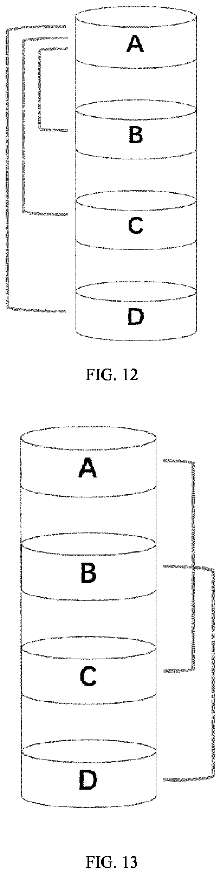

Furthermore, the capacitor plates formed by the division of the base body 10 form a plurality of groups of annular plates, in the form of one-to-many, as shown in FIG. 12, the capacitor plate A and the capacitor plate B form a group of electrodes, the capacitor plate A and the capacitor plate C form a group, and the capacitor plate A and the capacitor plate D form a group of electrodes. It can also be many-to-many, as shown in FIG. 13, the capacitor plate A and the capacitor plate C form a group of electrodes, and the capacitor plate B and the capacitor plate D form a group of electrodes.

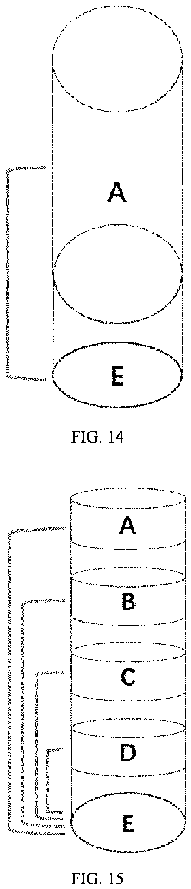

Correspondingly, in an embodiment, a capacitor plate divided from the base body 10 can also be used as the bottom plate of the base body 10, and the bottom plate and other corresponding capacitor plates form equivalent capacitors. The shape of the bottom plate can also be rectangular, circular, triangular, arched, spiral, and a composite of these shapes. As shown in FIG. 14, there is a bottom plate E at the bottom of the base body 10, and the bottom plate E and the annular capacitor plate form one or more equivalent capacitors. For example, as shown in FIG. 14, the capacitor plate A and the bottom plate E constitute an equivalent capacitor. Alternatively, as shown in FIG. 15, the capacitor plate A and the bottom plate E constitute an equivalent capacitor, the capacitor plate B and the bottom plate E constitute an equivalent capacitor, the capacitor plate C and the bottom plate E constitute an equivalent capacitor, and the capacitor plate D and the bottom plate E constitute an equivalent capacitor.

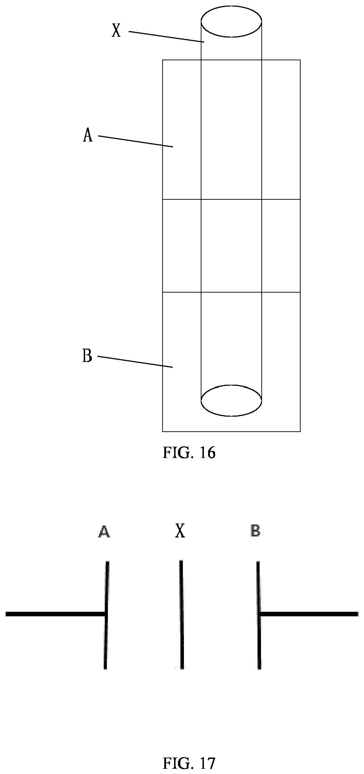

FIG. 16 is a simplified schematic diagram in which the aerosol generating substrate X is inserted into the base body. The aerosol generating substrate X is regarded as a plate of a capacitor. The capacitor plate A and the aerosol generating substrate X form a capacitor ①, and the capacitor plate B and the aerosol generating substrate X form a capacitor ②. The schematic diagram of the formed equivalent capacitors is shown in FIG. 17. A theoretical formula of capacitance is as follows:

$$C = \varepsilon \frac{S}{d}$$

where C refers to a capacitance value, ε refers to a dielectric constant between the capacitor plates, S refers to a plate area, and d refers to a distance between the plates. Because the conductivity of the aerosol generating substrate X is much smaller than the conductivity of the capacitor plate A and the capacitor plate B, when the aerosol generating substrate X is inserted between the capacitor plate A and the capacitor plate B, the dielectric constant ε of the material between the capacitor plate A and the capacitor plate B is changed, causing the capacitance between the capacitor plate A and the capacitor plate B to change. Depending on whether the capacitance of the capacitor formed by the capacitor plate A and the capacitor plate B changes, it can be identified whether the aerosol generating substrate X is inserted between the capacitor plate A and the capacitor plate B. The aerosol generating substrate X can be a cigarette, a solid medicine or other solid substances. In addition, the aerosol generating substrate X can also be a liquid substance contained in a solid container.

Furthermore, in the above theoretical formula of the capacitance, the plate area S and the distance d between the capacitor plates in an atomizer are fixed, and the dielectric constants of different aerosol generating substrate are different, so the capacitance values to be measured are also different. By acquiring capacitance values and setting capacitance value ranges of different substances, different types of aerosol generating substrates can be identified. For example, according to the following formulas:

$$C1 = \varepsilon 1 \frac{S}{d}$$

$$C2 = \varepsilon 2 \frac{S}{d}$$

if it is known that ε1 > ε2, it can be concluded that C1 > C2, and if it is known that ε1 < ε2, it can be concluded that C1 < C2.

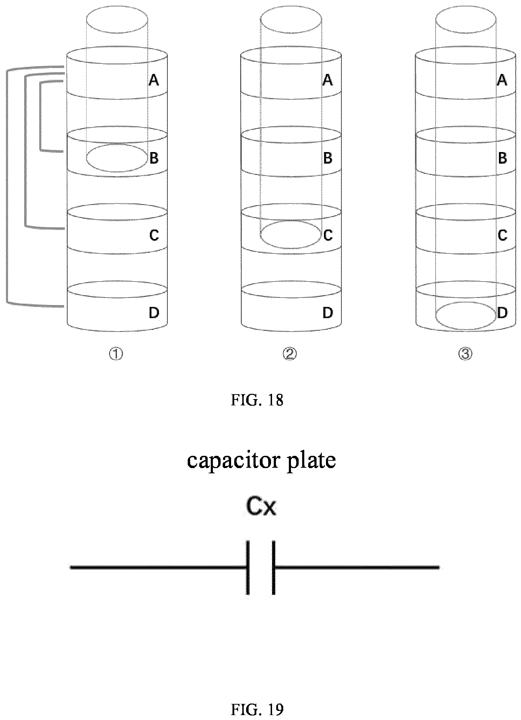

By setting a plurality of annular capacitor plates, for example, setting three or four annular capacitor plates, when the aerosol generating substrate reaches the position of a certain annular capacitor plate, the capacitance corresponding to the annular capacitor plate at the corresponding position can be measured to change, thereby determining the position of the aerosol generating substrate. According to this characteristic, the insertion state and the position of the aerosol generating substrate can be obtained, and then heating can be started, as well as the pulled out state and the position of the aerosol generating substrate can be obtained, and then the heating can be stopped. For example, as shown in FIG .18, the capacitor plate A and the capacitor plate B form a capacitor, the capacitor plate A and the capacitor plate C form a capacitor, and the capacitor plate A and the capacitor plate D form a capacitor. When the aerosol generating substrate is inserted into the position of the capacitor plate B as shown in FIG. 18-①, the capacitance of the capacitor plate A and the capacitor plate B changes. When the aerosol generating substrate is inserted into the position of the capacitor plate C as shown in FIG. 18-②, the capacitance of the capacitor plate A and the capacitor plate C changes. When the aerosol generating substrate is inserted into the position of the capacitor plate D as shown in FIG. 18-③, the capacitance of the capacitor plate A and the capacitor plate D changes. Based on this characteristic, position information of the inserted aerosol generating substrate can be obtained.

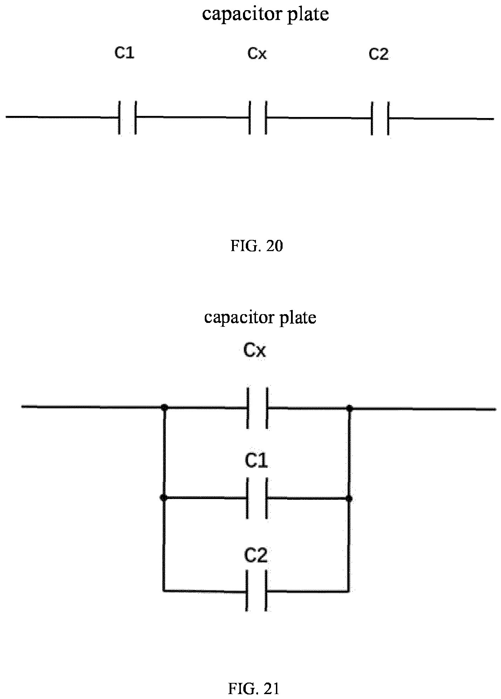

Based on different connection manners of the capacitance measuring assembly 100, the capacitance measuring assembly 100 can be categorized into two types: independent measured assembly and composite measured assembly. The composite measured assembly can further include a series-type and a parallel-type. As shown in FIG. 19, for the independent measured assembly, only the to-be measured capacitor need to be measured, and Cx refers to a capacitor plate. For the series-type composite measured assembly, as shown in FIG. 20, capacitor C1 and capacitor C2 are external measured capacitors connected in series with the capacitor plate Cx, and the capacitor C1 and the capacitor C2 are specifically capacitors in the capacitance acquisition component 220. The number of the capacitors connected in series with the capacitor plate Cx is not limited, it can be one, two, or more and can be adjusted according to actual needs. In addition, the capacitors connected in series with the capacitor plate Cx can be finished capacitors produced by a capacitor manufacturer or capacitors composed of structural parts.

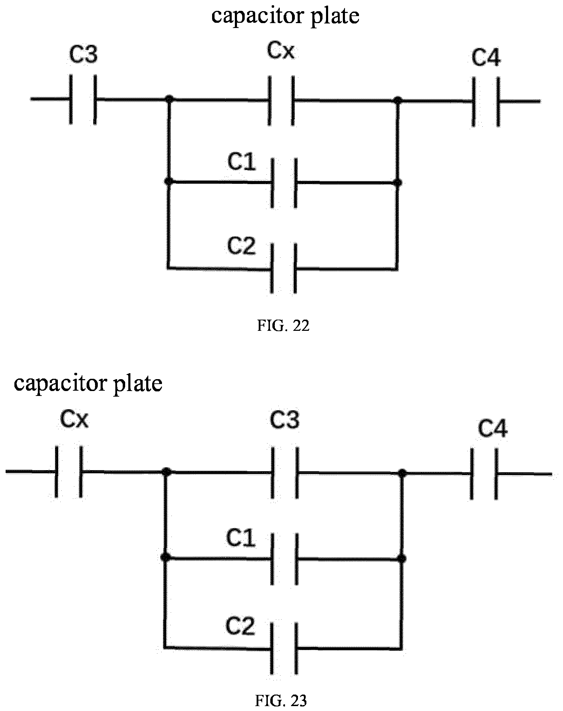

Further, for the parallel-type composite measured assembly, as shown in FIG. 21, capacitor C1 and capacitor C2 are external measured capacitors connected in parallel with the capacitor plate Cx. The capacitor C1 and the capacitor C2 are specifically capacitors in the capacitance acquisition component 220. The number of capacitors in parallel with the capacitor plate Cx is not limited, it can also be one, two or more, and can be adjusted according to actual needs. The capacitors in parallel with the capacitor plate Cx can be finished capacitors produced by a capacitor manufacturer or capacitors composed of structural parts. For the composite measured assembly of a parallel and series composite type, as shown in FIG. 22, capacitor C1 and capacitor C2 are external measured capacitors connected in parallel with the capacitor plate Cx, and capacitor C3 and capacitor C4 are external measured capacitors connected in series with the capacitor plate Cx. The capacitor C1, the capacitor C2, the capacitor C3 and the capacitor C4 are specifically capacitors in the capacitance acquisition component 220. As shown in FIG. 23, capacitor C3 and capacitor C4 are connected in series with the capacitor plate Cx. Capacitor C1, capacitor C2 and the capacitor C3 are connected in parallel. The capacitor C1, the capacitor C2, the capacitor C3 and the capacitor C4 are specifically capacitors in the capacitance acquisition component 220. The number of capacitors connected in parallel with the capacitor plate Cx is not limited, it can be one, two, or more, and can be adjusted according to actual needs. The capacitors connected in parallel with the capacitor plate Cx can be finished capacitors produced by a capacitor manufacturer or capacitors composed of structural parts. The number of capacitors connected in series with the capacitor plate Cx is not limited, it can be one, two, or more, and can be adjusted according to actual needs. The capacitors connected in series with the capacitor plate Cx can be finished capacitors produced by a capacitor manufacturer or capacitors composed of structural parts.

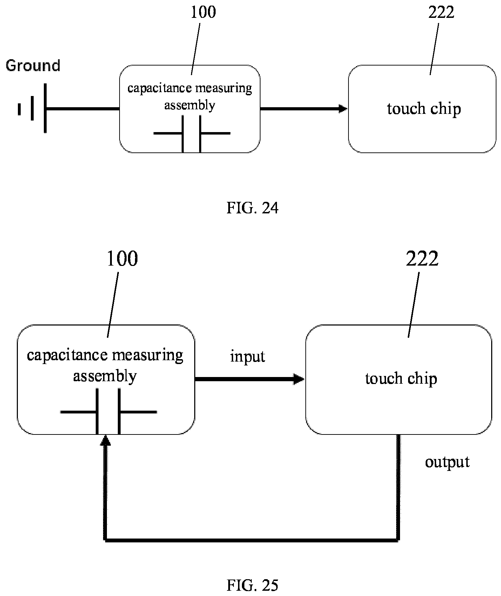

Taking a touch chip 222 being used as the capacitance acquisition component 220 as an example, a capacitance scanning principle of the touch chip 222 includes mutual capacitance scanning and self-capacitance scanning. Self-capacitance scanning is a scanning method of self-transmission and self-reception, and the capacitance measured by the touch chip 222 is the capacitance between an electrode and the ground. For mutual capacitance scanning, the touch chip 222 measures the capacitance between two electrodes. Based on different capacitance scanning methods of the touch chip, the connection between the touch chip 222 and the capacitance measuring assembly 100 includes the following two manners. As shown in FIG. 24, for the self-capacitance scanning, one of the plates of the to-be-measured capacitor in the capacitance measuring assembly 100 is connected to the ground, and the other plate is connected to a signal acquisition input terminal of the touch chip 222. As shown in FIG. 25, for the mutual capacitance scanning, one of the plates of the to-be-measured capacitor in the capacitance measuring assembly 100 is connected to a signal output terminal of the touch chip 222, and the other plate is connected to the signal acquisition input terminal of the touch chip 222.

An initial capacitance value of the capacitance measuring assembly 100 is periodically acquired and updated by the touch chip 222, and the initial capacitance value is used as the threshold value for determining the capacitance change. During insertion and pulling out of the aerosol generating substrate, the touch chip acquires a change of the capacitance value of each group of annular plates. The main control unit 240 can determine the position of the aerosol generating substrate and whether it is in the state of being inserted or being pulled out based on the capacitance value measured by the touch chip 222.

Further, the main control unit 240 may include a control chip and a discrete device. The control chip is configured for collecting data information from the touch chip 222 and making control actions based on the data information from the touch chip 222. The discrete device includes a power supply chip, a resistor, a capacitor, an inductor, a crystal oscillator, a memory, a logic gate circuit, etc. that support an operation of the control chip. During the insertion of the aerosol generating substrate, the touch chip 222 identifies the state of being inserted gradually based on the capacitance change of the annular capacitor plates at specific positions, and the main control unit 240 can start preheating in advance. When the aerosol generating substrate is inserted, the touch chip 222 identifies the completely inserted state based on the capacitance change of the annular capacitor plates at specific positions, and the main control unit 240 start the heating stage. Further, by setting capacitance value ranges corresponding to different types of solid aerosol generating substrates, the touch chip 222 identifies different types of the solid aerosol generating substrates based on the acquired capacitance values, and then the main control unit 240 adopts different heating control modes, such as adjusting to a heating method and a temperature control method corresponding to the identified solid aerosol generating substrate when the heating stage is started. In addition, by setting capacitance value ranges corresponding to different types of liquid aerosol generating substrates, the touch chip 222 can identify different types of the liquid aerosol generating substrates based on the acquired capacitance values, and then the main control unit 240 can adopt different heating methods and temperature control methods. For example, when the heating stage is started, it is adjusted to the heating method and temperature control method corresponding to the identified liquid aerosol generating substrate.

During the pulling out of the aerosol generating substrate, the touch chip 222 identifies the state of being pulled out gradually based on the capacitance change of the annular capacitor plates at specific positions, and the main control unit 240 can end the heating in advance or reduce the heating temperature. When the aerosol generating substrate is pulled out, the touch chip 222 identify the completely pulled out state based on the capacitance change of the annular capacitor plates at specific positions, and the main control unit 240 completely ends the heating.

In an embodiment, an aerosol generating device is also provided, including the above-mentioned atomization control device.

In the above-mentioned aerosol generating device, the capacitance of the capacitance measuring assembly changes based on whether an aerosol generating substrate is inserted. The capacitance processing assembly identifies a type of the aerosol generating substrate based on the capacitance of the capacitance measuring assembly, and determines a heating control mode for the aerosol generating device based on the type of the aerosol generating substrate. In this way, the heating control mode is automatically adjusted based on the type of the aerosol generating substrate without requiring a user to operate buttons, thereby improving the convenience of use.

The technical features of the above embodiments can be randomly combined. To simplify the description, not all possible combinations of the technical features in the above embodiments are described. However, as long as there is no contradiction in the combination of these technical features, all the combinations should be considered to be included within the scope of this specification.

The above-described embodiments only illustrate several embodiments of the present disclosure, and the descriptions of which are relatively specific and detailed, but should not be construed as limiting the scope of the patent disclosure. It should be noted that, for those of ordinary skill in the art, several modifications and improvements can be made without departing from the concept of the present disclosure, and these all fall within the protection scope of the present disclosure. Therefore, the protection scope of the present disclosure should be determined by the appended claims.

**Claims**

1. An atomization control device for an aerosol generating device, comprising:

   a capacitance measuring assembly configured to generate a capacitance change based on whether an aerosol generating substrate is inserted, capacitor plates of the capacitance measuring assembly being distributed along an insertion direction of the aerosol generating substrate; and
   a capacitance processing assembly configured to identify a type of the aerosol generating substrate based on a capacitance of the capacitance measuring assembly, and determine a heating control mode for the aerosol generating device based on the type of the aerosol generating substrate , the capacitance processing assembly being connected to the capacitance measuring assembly.

2. The atomization control device of claim 1, wherein the capacitance processing assembly is further configured to determine a state of the aerosol generating substrate based on the capacitance of the capacitance measuring assembly, and perform heating control on the aerosol generating device based on the state of the aerosol generating substrate .

3. The atomization control device of claim 2, wherein the capacitance processing assembly is further configured to control the aerosol generating device to start heating when it is identified that the aerosol generating substrate is inserted based on the capacitance of the capacitance measuring assembly, and control the aerosol generating device to stop heating when it is identified that the aerosol generating substrate is pulled out based on the capacitance of the capacitance measuring assembly.

4. The atomization control device of claim 3, wherein a number of the capacitor plates is three or more, and the capacitance processing assembly is configured to control the aerosol generating device to start a preheating stage when the aerosol generating substrate is in a state of being inserted, and control the aerosol generating device to start a heating stage when the aerosol generating substrate is completely inserted; and
   wherein the capacitance processing assembly is also configured to control the aerosol generating device to end the heating in advance or reduce a heating temperature when the aerosol generating substrate is in a state of being pulled out.

5. The atomization control device of claim 1, wherein the capacitance measuring assembly comprises a to-be-measured capacitor, and the to-be-measured capacitor is connected to the capacitance processing assembly.

6. The atomization control device of claim 5, wherein the to-be-measured capacitor comprises the capacitor plates and a base body made of a non-conductive material, and the capacitor plates are disposed on the base body; and
   wherein a number of the capacitor plates is two or more.

7. The atomization control device of claim 6, wherein the capacitor plates are closed annular plates or non-closed annular plates.

8. The atomization control device of claim 6, wherein the capacitor plates each comprise an annular portion and an extension portion disposed on the annular portion, the number of the capacitor plates is two, and the extension portions of the two capacitor plates are disposed opposite to each other.

9. The atomization control device of claim 6, wherein the base body is a hollow cylindrical base body, and the capacitor plates are located outside or inside of the base body and distributed along a longitudinal direction of the base body.

10. The atomization control device of claim 9, wherein a number of the capacitor plates is two, and the capacitor plates are located on a cylindrical inner wall or outer wall of the base body.

11. The atomization control device of claim 9, wherein a number of the capacitor plates is two, one end of the base body is closed to form a bottom wall, and one of the capacitor plates is disposed on the bottom wall of the base body.

12. The atomization control device of claim 6, wherein the to-be-measured capacitor further comprises a heating element disposed on the base body.

13. The atomization control device of claim 6, wherein the capacitor plates form annular plate groups in a one-to-many or many-to-many manner.

14. The atomization control device of claim 5, wherein the to-be-measured capacitor comprises a base body made of a conductive material, and the base body is divided into two or more of the capacitor plates.

15. The atomization control device of claim 14, wherein the capacitor plates are closed annular plates or non-closed annular plates.

16. The atomization control device of claim 14, wherein the to-be-measured capacitor further comprises an insulating member disposed between the capacitor plates .

17. The atomization control device of claim 16, wherein the capacitor plates and the insulating member are hollow and are configured to receive the aerosol generating substrate together.

18. The atomization control device of claim 14, wherein the capacitor plates form annular plate groups in a one-to-many or many-to-many manner.

19. The atomization control device of claim 1, wherein the capacitance processing assembly comprises a capacitance acquisition component and a main control unit, and the capacitance acquisition component is connected to the capacitance measuring assembly and the main control unit.

20. An aerosol generating device, comprising the atomization control device of any one of claims 1 to 19.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

capacitor plate

Cx

FIG. 19

capacitor plate

C1          Cx          C2

FIG. 20

capacitor plate

Cx

C1

C2

FIG. 21

capacitor plate

FIG. 22

capacitor plate

FIG. 23

100                                    222

Ground

capacitance measuring
assembly                              touch chip

FIG. 24

100                                    222

capacitance measuring        input
assembly                                touch chip

                                         output

FIG. 25

## INTERNATIONAL SEARCH REPORT

| International application No. |
| --- |
| **PCT/CN2022/138536** |

**A. CLASSIFICATION OF SUBJECT MATTER**

A24F40/51(2020.01)i;A24F40/40(2020.01)i

According to International Patent Classification (IPC) or to both national classification and IPC

**B. FIELDS SEARCHED**

Minimum documentation searched (classification system followed by classification symbols)

IPC: A24F, A61M, A24B

Documentation searched other than minimum documentation to the extent that such documents are included in the fields searched

Electronic data base consulted during the international search (name of data base and, where practicable, search terms used)

CNTXT, ENTXTC, VEN, ENTXT: 电容, 电极, 极板, capacitance, electrode

**C. DOCUMENTS CONSIDERED TO BE RELEVANT**

| Category* | Citation of document, with indication, where appropriate, of the relevant passages | Relevant to claim No. |
| --- | --- | --- |
| X | CN 106455707 A (BRITISH AMERICAN TOBACCO CO) 22 February 2017 (2017-02-22) claims, description, pages 4-10, and figures 2-9 | 1, 2, 5-20 |
| Y | CN 106455707 A (BRITISH AMERICAN TOBACCO CO) 22 February 2017 (2017-02-22) claims, description, pages 4-10, and figures 2-9 | 3, 4 |
| Y | CN 112315031 A (CHINA TOBACCO HENAN INDUSTRIAL CO., LTD.) 05 February 2021 (2021-02-05) claims, and description, pages 2-5 | 3, 4 |
| X | CN 113507848 A (KT&G CORP.) 15 October 2021 (2021-10-15) description, pages 7-12, and figures 1-13 | 1, 2, 5-20 |
| Y | CN 113507848 A (KT&G CORP.) 15 October 2021 (2021-10-15) description, pages 7-12, and figures 1-13 | 3, 4 |
| X | CN 108572202 A (SHENZHEN SMOORE TECHNOLOGY LIMITED) 25 September 2018 (2018-09-25) description, pages 3-8, and figures 2-5 | 1, 2, 5-20 |

☑ Further documents are listed in the continuation of Box C.   ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **01 March 2023** | **03 March 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

**EP 4 487 718 A1**

<table>
<tr><td colspan="2" align="center">**INTERNATIONAL SEARCH REPORT**</td><td>International application No.<br>**PCT/CN2022/138536**</td></tr>
</table>

**C.    DOCUMENTS CONSIDERED TO BE RELEVANT**

| Category* | Citation of document, with indication, where appropriate, of the relevant passages | Relevant to claim No. |
|---|---|---|
| Y | CN 108572202 A (SHENZHEN SMOORE TECHNOLOGY LIMITED) 25 September 2018 (2018-09-25)<br>      description, pages 3-8, and figures 2-5 | 3, 4 |
| PX | CN 114568763 A (SHENZHEN MAISHI TECHNOLOGY CO., LTD.) 03 June 2022 (2022-06-03)<br>      claims, description, pages 3-9, and figures 1-25 | 1-20 |
| PX | JP 2022118714 A (EM-TECH CO., LTD.) 15 August 2022 (2022-08-15)<br>      claims, description, pages 3-6, and figures 2-6 | 1-20 |
| PX | CN 114582631 A (SHENZHEN MAISHI TECHNOLOGY CO., LTD.) 03 June 2022 (2022-06-03)<br>      description, pages 3-7, and figures 1-22 | 1-20 |
| A | CN 107949288 A (PHILIP MORRIS PRODUCTS S.A.) 20 April 2018 (2018-04-20)<br>      entire document | 1-20 |
| A | CN 110022705 A (PHILIP MORRIS PRODUCTS S.A.) 16 July 2019 (2019-07-16)<br>      entire document | 1-20 |
| A | CN 111787821 A (KT&G CORP.) 16 October 2020 (2020-10-16)<br>      entire document | 1-20 |
| A | CN 111918566 A (BRITISH AMERICAN TOBACCO INVESTMENTS LTD.) 10 November 2020 (2020-11-10)<br>      entire document | 1-20 |
| A | CN 112911956 A (PHILIP MORRIS PRODUCTS S.A.) 04 June 2021 (2021-06-04)<br>      entire document | 1-20 |
| A | WO 2021006611 A2 (EM-TECH CO., LTD.) 14 January 2021 (2021-01-14)<br>      entire document | 1-20 |
| A | WO 2022033528 A1 (SHENZHEN FIRST UNION TECHNOLOGY CO., LTD.) 17 February 2022 (2022-02-17)<br>      entire document | 1-20 |
| A | WO 2022039378 A1 (KT & G CORP.) 24 February 2022 (2022-02-24)<br>      entire document | 1-20 |

Form PCT/ISA/210 (second sheet) (July 2022)

INTERNATIONAL SEARCH REPORT
Information on patent family members

International application No.

**PCT/CN2022/138536**

| Patent document cited in search report | | | Publication date (day/month/year) | Patent family member(s) | | | Publication date (day/month/year) |
|---|---|---|---|---|---|---|---|
| CN | 106455707 | A | 22 February 2017 | EP | 3119224 | A1 | 25 January 2017 |
| | | | | UA | 123621 | C2 | 05 May 2021 |
| | | | | JP | 2017510270 | A | 13 April 2017 |
| | | | | JP | 6348985 | B2 | 27 June 2018 |
| | | | | RU | 2016137560 | A3 | 23 March 2018 |
| | | | | RU | 2016137560 | A | 31 May 2018 |
| | | | | CA | 2940693 | A1 | 24 September 2015 |
| | | | | CA | 2940693 | C | 24 July 2018 |
| | | | | AU | 2015233388 | A1 | 01 September 2016 |
| | | | | AU | 2015233388 | B2 | 08 June 2017 |
| | | | | KR | 20160124853 | A | 28 October 2016 |
| | | | | KR | 101971169 | B1 | 22 April 2019 |
| | | | | MY | 179623 | A | 11 November 2020 |
| | | | | KR | 20190014596 | A | 12 February 2019 |
| | | | | KR | 102123900 | B1 | 17 June 2020 |
| | | | | US | 2018049469 | A1 | 22 February 2018 |
| | | | | US | 10687553 | B2 | 23 June 2020 |
| | | | | BR | 112016021596 | A2 | 15 August 2017 |
| | | | | BR | 112016021596 | B1 | 23 August 2022 |
| | | | | US | 2020260790 | A1 | 20 August 2020 |
| | | | | WO | 2015140312 | A1 | 24 September 2015 |
| CN | 112315031 | A | 05 February 2021 | None | | | |
| CN | 113507848 | A | 15 October 2021 | EP | 3883412 | A1 | 29 September 2021 |
| | | | | EP | 3883412 | A4 | 03 November 2021 |
| | | | | KR | 20210101041 | A | 18 August 2021 |
| | | | | KR | 102337231 | B1 | 08 December 2021 |
| | | | | WO | 2021157840 | A1 | 12 August 2021 |
| | | | | JP | 2022522608 | A | 20 April 2022 |
| | | | | US | 2022400769 | A1 | 22 December 2022 |
| CN | 108572202 | A | 25 September 2018 | None | | | |
| CN | 114568763 | A | 03 June 2022 | None | | | |
| JP | 2022118714 | A | 15 August 2022 | KR | 20220111441 | A | 09 August 2022 |
| CN | 114582631 | A | 03 June 2022 | None | | | |
| CN | 107949288 | A | 20 April 2018 | IL | 257572 | A | 30 April 2018 |
| | | | | WO | 2017051016 | A1 | 30 March 2017 |
| | | | | RU | 2018114886 | A | 24 October 2019 |
| | | | | RU | 2018114886 | A3 | 21 November 2019 |
| | | | | KR | 20180058712 | A | 01 June 2018 |
| | | | | CA | 2999214 | A1 | 30 March 2017 |
| | | | | JP | 2018532390 | A | 08 November 2018 |
| | | | | JP | 6924180 | B2 | 25 August 2021 |
| | | | | MX | 2018003279 | A | 16 May 2018 |
| | | | | EP | 3352595 | A1 | 01 August 2018 |
| | | | | EP | 3352595 | B1 | 04 November 2020 |
| | | | | US | 2018206553 | A1 | 26 July 2018 |
| | | | | US | 10939704 | B2 | 09 March 2021 |
| CN | 110022705 | A | 16 July 2019 | EP | 3558038 | A1 | 30 October 2019 |
| | | | | EP | 3558038 | B1 | 30 November 2022 |
| | | | | MX | 2019006997 | A | 22 August 2019 |

Form PCT/ISA/210 (patent family annex) (July 2022)

**INTERNATIONAL SEARCH REPORT**
Information on patent family members

| International application No. |
|---|
| **PCT/CN2022/138536** |

| Patent document cited in search report | | | Publication date (day/month/year) | Patent family member(s) | | | Publication date (day/month/year) |
|---|---|---|---|---|---|---|---|
| | | | | CA | 3041089 | A1 | 28 June 2018 |
| | | | | WO | 2018114849 | A1 | 28 June 2018 |
| | | | | RU | 2019118259 | A | 22 January 2021 |
| | | | | RU | 2019118259 | A3 | 19 April 2021 |
| | | | | RU | 2765142 | C2 | 26 January 2022 |
| | | | | AR | 110392 | A1 | 27 March 2019 |
| | | | | IL | 267378 | A | 29 August 2019 |
| | | | | TW | 201825827 | A | 16 July 2018 |
| | | | | JP | 2020501552 | A | 23 January 2020 |
| | | | | JP | 7134966 | B2 | 12 September 2022 |
| | | | | KR | 20190089908 | A | 31 July 2019 |
| CN | 111787821 | A | 16 October 2020 | JP | 2021513325 | A | 27 May 2021 |
| | | | | JP | 7045463 | B2 | 31 March 2022 |
| | | | | US | 2020367568 | A1 | 26 November 2020 |
| | | | | WO | 2020149503 | A1 | 23 July 2020 |
| | | | | KR | 20200089149 | A | 24 July 2020 |
| | | | | KR | 102262490 | B1 | 08 June 2021 |
| | | | | EP | 3818895 | A1 | 12 May 2021 |
| | | | | EP | 3818895 | A4 | 15 September 2021 |
| CN | 111918566 | A | 10 November 2020 | CA | 3094956 | A1 | 03 October 2019 |
| | | | | GB | 201805234 | D0 | 16 May 2018 |
| | | | | BR | 112020020021 | A2 | 05 January 2021 |
| | | | | MX | 2020010208 | A | 09 November 2020 |
| | | | | AU | 2022275522 | A1 | 05 January 2023 |
| | | | | JP | 2021104010 | A | 26 July 2021 |
| | | | | JP | 2021516986 | A | 15 July 2021 |
| | | | | US | 2021015167 | A1 | 21 January 2021 |
| | | | | AU | 2019246399 | A1 | 08 October 2020 |
| | | | | AU | 2019246399 | B2 | 01 September 2022 |
| | | | | NZ | 768072 | A | 30 September 2022 |
| | | | | EP | 3773027 | A1 | 17 February 2021 |
| | | | | IL | 277512 | A | 30 November 2020 |
| | | | | WO | 2019185715 | A1 | 03 October 2019 |
| | | | | KR | 20200121894 | A | 26 October 2020 |
| | | | | RU | 2768548 | C1 | 24 March 2022 |
| | | | | EP | 3799749 | A2 | 07 April 2021 |
| | | | | EP | 3799749 | A3 | 30 June 2021 |
| | | | | RU | 2020135636 | A | 13 November 2020 |
| | | | | RU | 2020135636 | A3 | 06 April 2021 |
| | | | | RU | 2766080 | C2 | 07 February 2022 |
| CN | 112911956 | A | 04 June 2021 | US | 2022039478 | A1 | 10 February 2022 |
| | | | | RU | 2765699 | C1 | 02 February 2022 |
| | | | | KR | 20210082517 | A | 05 July 2021 |
| | | | | JP | 2022512442 | A | 03 February 2022 |
| | | | | WO | 2020126908 | A1 | 25 June 2020 |
| | | | | EP | 3897247 | A1 | 27 October 2021 |
| | | | | BR | 112021007013 | A2 | 13 July 2021 |
| WO | 2021006611 | A2 | 14 January 2021 | JP | 2022540456 | A | 15 September 2022 |
| | | | | WO | 2021006611 | A3 | 11 March 2021 |

Form PCT/ISA/210 (patent family annex) (July 2022)

**INTERNATIONAL SEARCH REPORT**
**Information on patent family members**

| International application No. |
| --- |
| **PCT/CN2022/138536** |

| Patent document cited in search report | | | Publication date (day/month/year) | Patent family member(s) | | | Publication date (day/month/year) |
| --- | --- | --- | --- | --- | --- | --- | --- |
| WO | 2022033528 | A1 | 17 February 2022 | None | | | |
| WO | 2022039378 | A1 | 24 February 2022 | EP | 4087427 | A1 | 16 November 2022 |
| | | | | KR | 20220022757 | A | 28 February 2022 |

Form PCT/ISA/210 (patent family annex) (July 2022)

**EP 4 487 718 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210215103